# EUROPÄISCHE PATENTANMELDUNG

(11) **EP 1 189 236 A1**
(43) Veröffentlichungstag der Anmeldung: **20.03.2002**
(21) Anmeldenummer: 01114672.7
(22) Anmeldetag: 19.06.2001
(51) Int. Cl.: G11C 11/16

(54) **Integrierter Speicher mit Speicherzellen mit magnetoresistivem Speichereffekt und Verfahren zum Betrieb eines solchen Speichers**

(30) Priorität: 03.07.2000 DE 10032275
(71) Anmelder: Infineon Technologies AG, 81669 München (DE)
(72) Erfinder: Pöchmüller, Peter, Dr., Colchester, VT 05446 (US)
(74) Vertreter: Epping Hermann & Fischer

(57) **Zusammenfassung**

Ein integrierter Speicher weist Speicherzellen (MC) mit magnetoresistivem Speichereffekt auf, die jeweils zwischen Spaltenleitungen (BL0 bis BLn) und Zeilenleitungen (WL0 bis WLm) geschaltet sind. Eine der Zeilenleitungen (WL2) ist zum Auslesen eines Datensignals (DA) einer mit der Zeilenleitung (WL2) verbundenen Speicherzelle (MC2) in einer Auswahlschaltung (2) mit einem Anschluß für ein Auswahlsignal (GND) verbunden. Die anderen Zeilenleitungen (WL0, WL1, WLm) werden derart angesteuert, daß sie zum Auslesen des Datensignals (DA) in der Auswahlschaltung (2) elektrisch isoliert sind. Dadurch ist ein vergleichsweise zuverlässiger Auslesevorgang ermöglicht.

## Beschreibung

Integrierter Speicher mit Speicherzellen mit magnetoresistivem Speichereffekt und Verfahren zum Betrieb eines solchen Speichers

Die vorliegende Erfindung betrifft einen integrierten Speicher mit Speicherzellen mit magnetoresistivem Speichereffekt, die zwischen jeweils eine von mehreren Spaltenleitungen und jeweils eine von mehreren Zeilenleitungen geschaltet sind, sowie ein Verfahren zum Betrieb eines solchen Speichers

Speicherzellen mit magnetoresistivem Speichereffekt weisen zur Speicherung von Datensignalen im allgemeinen in ihrem Zustand veränderbare ferromagnetische Schichten auf. Dieser Speichereffekt ist allgemein als sogenannter GMR-Effekt (Giant Magnetoresitive) oder TMR-Effekt (Tunnelling Magnetoresistive) bekannt. Dabei ist der elektrische Widerstand einer derartigen Speicherzelle abhängig von der Magnetisierung in den ferromagnetischen Schichten.

Integrierte Speicher mit derartigen Speicherzellen, auch als sogenannte MRAM-Speicher bezeichnet, sind oftmals ähnlich aufgebaut wie beispielsweise integrierte Speicher vom Typ DRAM. Derartige Speicher weisen im allgemeinen eine Speicherzellenanordnung mit untereinander im wesentlichen parallel verlaufenden Zeilenleitungen und Spaltenleitungen auf, wobei die Zeilenleitungen üblicherweise quer zu den Spaltenleitungen verlaufen.

Ein derartiger MRAM-Speicher ist aus WO 99/14760 bekannt. Dort sind die Speicherzellen jeweils zwischen eine der Zeilenleitungen und eine der Spaltenleitungen geschaltet und mit der jeweiligen Spaltenleitung und Zeilenleitung elektrisch verbunden. Die Speicherzellen mit magnetoresistivem Speichereffekt sind dabei hochohmiger als die Zeilenleitungen und Spaltenleitungen. Die Zeilenleitungen werden jeweils mit einem Anschluß für ein Auswahlsignal verbunden zum Auslesen eines Datensignals einer der Speicherzellen über die mit der Speicherzelle verbundene Spaltenleitung. Die Spaltenleitungen sind zum Auslesen eines Datensignals einer der Speicherzellen mit einem Leseverstärker verbunden. Zum Auslesen wird der auf der Spaltenleitung detektierbare Strom gemessen.

Bei einem derartigen MRAM-Speicher sind keine Dioden oder Transistoren vorhanden, die zum Auslesen oder Schreiben eines Datensignals die Speicherzellen abhängig von der Adressierung mit der jeweiligen Spaltenleitung verbinden. Dadurch erhält man insbesondere Vorteile bei der geometrischen Anordnung der Speicherzellen.

Für einen ordnungsgemäßen Auslesevorgang ist es wichtig, daß alle Spaltenleitungen und Zeilenleitungen bis auf die ausgewählte Zeilenleitung ein gleiches Potential aufweisen. Sind beispielsweise die Potentiale zwischen der auszulesenden Spaltenleitung und einer nicht ausgewählten Zeilenleitung unterschiedlich, so wird der zu detektierende Strom durch parasitäre Ströme überlagert, die durch diesen Potentialunterschied auf der auszulesenden Spaltenleitung entstehen. Dies kann zu einem fehlerhaften Auslesevorgang der auszulesenden Speicherzelle führen.

Die Zeilenleitungen sind im allgemeinen mit Zeilenleitungstreibern verbunden, so daß die Zeilenleitungen ein vorgegebenes Potential aufweisen. Die Spaltenleitungen werden über entsprechende Leseverstärker mit einem entsprechenden Potential beaufschlagt. Insbesondere bei räumlich verteilten Anordnungen von Zeilenleitungstreibern und Leseverstärkern entlang des Speicherzellenfeldes des integrierten Speichers ist es vergleichsweise schwierig, die Zeilenleitungstreiber und Leseverstärker so auszulegen beziehungsweise zu betreiben, daß die entsprechenden Spaltenleitungen und Zeilenleitungen jeweils ein exakt gleiches Potential aufweisen.

Die Aufgabe der vorliegenden Erfindung ist es, einen integrierten Speicher mit Speicherzellen mit magnetoresistivem Speichereffekt der eingangs genannten Art anzugeben, bei dem ein vergleichsweise zuverlässiges Auslesen einer der Speicherzellen ermöglicht ist.

Außerdem ist es Aufgabe der vorliegenden Erfindung, ein Verfahren zum Betrieb eines integrierten Speichers der eingangs genannten Art anzugeben, durch das ein vergleichsweise zuverlässiger Auslesevorgang einer der Speicherzellen ermöglicht ist.

Die Aufgabe betreffend den integrierten Speicher wird gelöst durch einen integrierten Speicher der eingangs genannten Art, bei dem die Zeilenleitungen mit einer Auswahlschaltung verbunden sind, bei dem jeweils eine der Zeilenleitungen in der Auswahlschaltung mit einem Anschluß für ein Auswahlsignal verbindbar ist zum Auslesen eines Datensignals einer mit der Zeilenleitung verbundenen Speicherzelle und bei dem die Auswahlschaltung derart ausgebildet und durch Steuermittel ansteuerbar ist, daß die nicht mit der Speicherzelle verbundenen Zeilenleitungen zum Auslesen des Datensignals in der Auswahlschaltung elektrisch isoliert sind.

Die Aufgabe betreffend das Verfahren wird gelöst durch ein Verfahren zum Betrieb eines integrierten Speichers der eingangs genannten Art, bei dem während eines Auslesevorgangs eine der Zeilenleitungen in einer Auswahlschaltung mit einem Anschluß für ein Auswahlsignal verbunden wird und ein Auslesen eines Datensignals einer mit der Zeilenleitung verbundenen Speicherzelle erfolgt, und bei dem die nicht mit der Speicherzelle verbundenen Zeilenleitungen während des Auslesevorgangs in der Auswahlschaltung elektrisch isoliert werden.

Durch den erfindungsgemäßen integrierten Speicher beziehungsweise durch das erfindungsgemäße Verfahren zum Betrieb eines integrierten Speichers wird es ermöglicht, parasitäre Ströme während des Auslesens eines Datensignals einer der Speicherzellen zu vermeiden. Dies wird dadurch erreicht, indem die nicht ausgewählten Zeilenleitungen derart angesteuert werden, daß sie in der Auswahlschaltung während des Auslesens elektrisch isoliert sind. Diese Zeilenleitungen weisen demzufolge eine Art schwebenden oder floatenden Zustand auf und können auf ein einheitliches Potential gebracht werden. Durch das Vermeiden von parasitären Strömen wird ein vergleichsweise zuverlässiges Auslesen des Datensignals ermöglicht, da der zu detektierende Strom, über den Rückschlüsse auf die gespeicherte Information in der Speicherzelle getroffen werden, nicht durch parasitäre Ströme überlagert beziehungsweise verfälscht wird.

In einer Ausführungsform des erfindungsgemäßen Speichers sind die Zeilenleitungen jeweils mit einer Treiberschaltung verbunden, die in einem leitenden Zustand oder in einem nicht leitenden Zustand betreibbar ist. Über diese Treiberschaltungen sind nicht ausgewählte Zeilenleitungen so ansteuerbar, daß sie zum Auslesen des Datensignals elektrisch isoliert sind. Dazu werden die Treiberschaltungen in dem nicht leitenden Zustand betrieben. Die jeweilige Treiberschaltung weist beispielsweise Schaltmittel in Form von Transistoren auf, die über ihre Source-Drain-Strecken mit der jeweiligen Zeilenleitung verbunden sind. Diese Transistoren werden in einem entsprechenden nicht leitenden Zustand betrieben.

In einer Ausführungsform des erfindungsgemäßen Verfahrens werden die Zeilenleitungen auf ein gemeinsames Vorladepotential vorgeladen. Nach dem Vorladen erfolgt das Auslesen des Datensignals. Dies kann über geeignete Vorlademittel des Speichers erfolgen. Auf diese Weise kann sichergestellt werden, daß die floatenden Zeilenleitungen unmittelbar vor dem jeweiligen Auslesen eines Datensignals ein gemeinsames Potential aufweisen. Dabei wird mit dem Auslesen des Datensignals vorzugsweise solange gewartet, bis die jeweiligen Potentialverläufe auf den Zeilenleitungen einen statischen Zustand aufweisen.

In einer weiteren Ausführungsform der Erfindung werden die Zeilenleitungen über wenigstens eine der Spaltenleitungen vorgeladen. Dabei ist es vorteilhaft, die Zeilenleitungen über alle Spaltenleitungen vorzuladen. Die Zeilenleitungen werden dabei über die jeweiligen Speicherzellen auf das Potential der jeweiligen Spaltenleitungen aufgeladen. Da die Speicherzellen eine Widerstandscharakteristik aufweisen, ist es gewährleistet, daß die Zeilenleitungen exakt das Potential der Spaltenleitungen annehmen, wenn ein statischer Zustand erreicht ist. Insgesamt ist dadurch sichergestellt, daß alle nicht ausgewählten Zeilenleitungen und die Spaltenleitungen unmittelbar vor dem Auslesen ein gleiches Potential aufweisen.

In einer Weiterbildung der Erfindung werden die Spaltenleitungen durch einen Leseverstärker vorgeladen, der außerdem zum Auslesen eines Datensignals einer ausgewählten Speicherzelle dient. Der Leseverstärker ist zum Auslesen des Datensignals mit der entsprechenden Spaltenleitung verbunden. Das Vorladen der Spaltenleitungen beziehungsweise der Zeilenleitungen durch einen oder mehrere Leseverstärker wird vor dem jeweiligen Auslesen durchgeführt. Der jeweilige Leseverstärker ist dazu als geeignetes Vorlademittel ausgebildet. Die Zeitdauer bis zum Erreichen eines Potentialausgleichs zwischen den Spaltenleitungen und Zeilenleitungen fällt nicht wesentlich ins Gewicht, da über die parallele Schaltung der Speicherzellen zwischen den Spaltenleitungen und einer der Zeilenleitungen ein zügiger Potentialausgleich erreicht werden kann.

Weitere vorteilhafte Aus- und Weiterbildungen sind in Unteransprüchen gekennzeichnet.

Die Erfindung wird im folgenden anhand der in der Zeichnung dargestellten Figuren, die jeweils Ausführungsbeispiele darstellen, näher erläutert. Es zeigen:
- Figur 1: eine Ausführungsform des erfindungsgemäßen integrierten Speichers mit magnetoresistiven Speicherzellen,
- Figur 2: eine Ausführungsform einer Zeilenauswahlschaltung gemäß Figur 1.

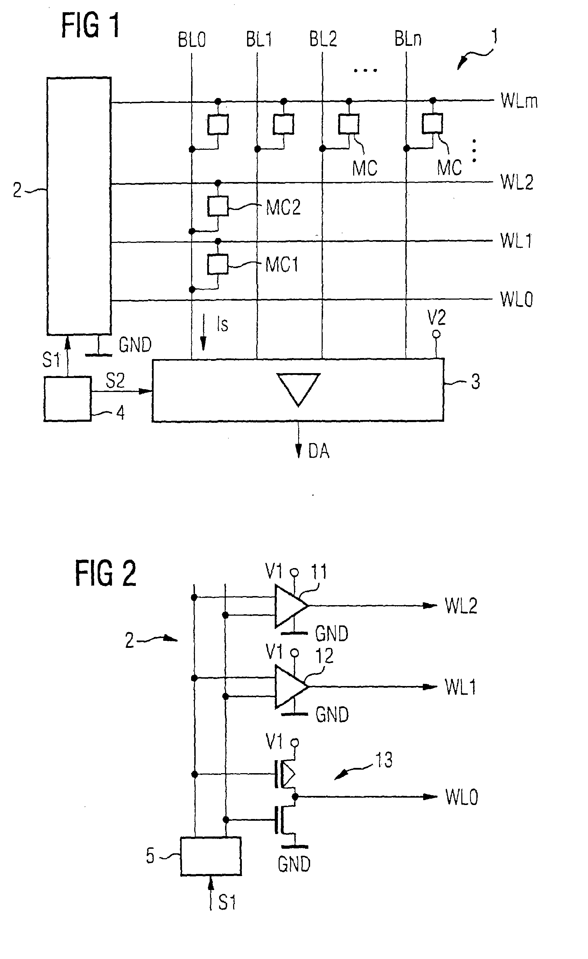

Figur 1 zeigt ein Ausführungsbeispiel eines erfindungsgemäßen Speichers mit Speicherzellen MC mit magnetoresistivem Speichereffekt. Als Speicherzellen sind alle bekannten GMR-/TMR-Elemente geeignet, sofern sie hochohmiger sind als die Spaltenleitungen und Zeilenleitungen. Die Spaltenleitungen sind hier als Bitleitungen BL0 bis BLn bezeichnet, die Zeilenleitungen als Wortleitungen WL0 bis WLm. Der Speicher weist hier eine beispielhafte Anzahl von Wortleitungen und Bitleitungen auf. Die Speicherzellen MC, die in einem matrixförmigem Speicherzellenfeld 1 angeordnet sind, sind jeweils zwischen eine der Bitleitungen BL0 bis BLn und eine der Wortleitungen WL0 bis WLm geschaltet. Die Wortleitungen WL0 bis WLm sind außerdem mit einer Zeilenauswahlschaltung 2 verbunden. Die Bitleitungen BL0 bis BLn sind mit einem Leseverstärker 3 verbunden, durch den ein Datensignal DA einer der Speicherzellen MC auslesbar ist. Zum Auslesen eines Datensignals DA ist diejenige Bitleitung mit dem Leseverstärker 3 verbunden, an der die auszulesende Speicherzelle angeschlossen ist. Die Auswahlschaltung 2 und der Leseverstärker 3 sind über die Zugriffssteuerung 4 als Steuermittel über die Signale S1 und S2 in geeigneter Weise ansteuerbar.

Zum Auslesen einer in einer Speicherzelle gespeicherten Information wird die betreffende Wortleitung angesteuert. Diese wird dazu mit einem Auswahlsignal beziehungsweise einem vorgegebenen Auswahlpotential beaufschlagt, so daß ein Stromfluß durch die auszulesende Speicherzelle auftritt. Dabei ist es wichtig, daß alle anderen Wortleitungen und die Bitleitungen an einem gleichen Potential anliegen, beispielsweise einem Potential V2 des integrierten Speichers. Die an der auszulesenden Speicherzelle angeschlossene Bitleitung wird zum Auslesen des Datensignals DA mit dem Leseverstärker 3 verbunden, der diesen Stromfluß detektiert.

Im folgenden sei angenommen, daß ein Datensignal DA der Speicherzelle MC2 auszulesen ist. Vor dem Auslesen ist sicherzustellen, daß alle Bitleitungen BL0 bis BLn und Wortleitungen WL0 bis WLm ein gleiches Potential aufweisen, so daß kein Stromfluß durch die Speicherzellen auftritt. Die Wortleitungen werden dabei durch die Auswahlschaltung 2 entsprechend mit einem gleichen Potential verbunden, wie die Bitleitungen durch den Leseverstärker 3. Zum Auslesen des Datensignals DA der Speicherzelle MC2 wird anschließend die Wortleitung WL2 mit einem entsprechenden Auswahlpotential verbunden. Dadurch tritt zwischen der Wortleitung WL2 und der Bitleitung BLO ein Strom IS durch die Speicherzelle MC2 auf. Dabei ist der Widerstand der Speicherzelle MC2 abhängig von der in der Speicherzelle MC2 gespeicherten Information. Der daraus resultierende Strom IS wird vom Leseverstärker 3 detektiert und daraus das entsprechende Datensignal DA der Speicherzelle MC2 erzeugt. Weist bei einem derartigen Auslesevorgang beispielsweise die Wortleitung WL1 ein zur Bitleitung BL0 unterschiedliches Potential auf, so wird durch die Speicherzelle MC1 auf der Bitleitung BL0 ein parasitärer Strom erzeugt, der den Auslesestrom IS überlagert beziehungsweise verfälscht. Dabei ist es möglich, daß das Datensignal DA nicht ordnungsgemäß ausgelesen wird, zum Beispiel infolge einer dadurch verfälschten Schwellwertentscheidung.

In einer erfindungsgemäßen Ausführungsform wird nun vorgesehen, daß für diesen Fall die Wortleitungen WL0, WL1 und WLm während des Auslesens des Datensignals DA aus der Speicherzelle MC2 in der Auswahlschaltung 2 elektrisch isoliert werden. Die Wortleitung WL2 ist zum Auslesen des Datensignals DA beispielsweise mit einem Auswahlpotential GND verbunden. Die Wortleitungen WL0, WL1 und WLm weisen eine Art schwebenden beziehungsweise floatenden Zustand auf. Um sicherzustellen, daß alle Bitleitungen BL0 bis BLn und die Wortleitungen WL0, WL1 und WLm während des Auslesevorgangs ein gleiches Potential aufweisen, werden diese auf das gemeinsame Vorladepotential V2 vorgeladen. Dies wird beispielsweise durch den Leseverstärker 3 durchgeführt, der dazu mit den entsprechenden Bitleitungen verbunden ist.

Da die Wortleitungen über die Speicherzellen MC mit den Bitleitungen verbunden sind, stellt sich dadurch ein Potentialausgleich ein. Dabei wird mit dem anschließenden Auslesen solange gewartet, bis die jeweiligen Potentialverläufe auf den Wortleitungen und Bitleitungen einen statischen Zustand aufweisen. Da die Speicherzellen MC eine Widerstandscharakteristik aufweisen, ist gewährleistet, daß ein vollständiger Potentialausgleich zwischen den Bitleitungen und Wortleitungen eintritt. Dadurch ist gewährleistet, daß vor und während des Auslesens des Datensignals DA keine parasitären Ströme auf der betreffenden Spaltenleitung auftreten. Unmittelbar nach dem Vorladen durch den Leseverstärker 3 wird ein Auslesen der Speicherzelle MC2 eingeleitet. Dazu bleiben die vorgeladenen Wortleitungen WL0, WL1 und WLm in der Auswahlschaltung 2 elektrisch isoliert.

Figur 2 zeigt eine Ausführungsform der Zeilenauswahlschaltung 2 gemäß Figur 1. Die hier gezeigten Wortleitungen WL0, WL1 und WL2 sind jeweils mit Treiberschaltungen 11, 12 beziehungsweise 13 verbunden. Die Treiberschaltungen 11 bis 13 sind dabei gleich aufgebaut, wie am Beispiel der Treiberschaltung 13 dargestellt. Die Treiberschaltungen weisen jeweils einen PMOS-Transistor und einem NMOS-Transistor auf, die von einer logischen Schaltung 5 ansteuerbar sind. Die logische Schaltung 5 wird von dem Signal S1 der Zugriffssteuerung 4 angesteuert. Außerhalb eines Auslesevorgangs sind die Wortleitungen über die entsprechenden Transistoren mit dem Potential V1 verbunden. Zur Auswahl beispielsweise der Wortleitung WL2 wird diese über den entsprechenden Transistor mit dem Bezugspotential GND verbunden. Um die Wortleitung WL1 und WL0 während des Auslesevorgangs zu isolieren, sind die Treiberschaltungen 12 und 13 während des Auslesevorgangs in einem nicht leitenden Zustand. Die Wortleitungen WL0 und WL1 können daher durch den Leseverstärker 3 aus Figur 1 auf das Vorladepotential V2 vorgeladen werden. Für den nicht leitenden Zustand der jeweiligen Treiberschaltung werden deren Transistoren in einen sperrenden Zustand versetzt.

## Patentansprüche

1. Integrierter Speicher mit Speicherzellen (MC) mit magnetoresistivem Speichereffekt, die zwischen jeweils eine von mehreren Spaltenleitungen (BL0 bis BLn) und jeweils eine von mehreren Zeilenleitungen (WL0 bis WLm) geschaltet sind,
**dadurch gekennzeichnet, daß**
- die Zeilenleitungen (WL0 bis WLm) mit einer Auswahlschaltung (2) verbunden sind,
- jeweils eine der Zeilenleitungen (WL2) in der Auswahlschaltung (2) mit einem Anschluß für ein Auswahlsignal (GND) verbindbar ist zum Auslesen eines Datensignals (DA) einer mit der Zeilenleitung (WL2) verbundenen Speicherzelle (MC2),
- die Auswahlschaltung (2) derart ausgebildet und durch Steuermittel (4) ansteuerbar ist, daß die nicht mit der Speicherzelle (MC2) verbundenen Zeilenleitungen (WL0, WL1, WLm) zum Auslesen des Datensignals (DA) in der Auswahlschaltung (2) elektrisch isoliert sind.

2. Integrierter Speicher nach Anspruch 1,
**dadurch gekennzeichnet, daß**
die Zeilenleitungen (WL0 bis WLm) jeweils mit einer Treiberschaltung (11 bis 13) verbunden sind, die in einem leitenden Zustand oder in einem nicht leitenden Zustand betreibbar ist.

3. Integrierter Speicher nach Anspruch 1 oder 2,
**dadurch gekennzeichnet, daß**
der integrierte Speicher wenigstens ein Vorlademittel (3) aufweist zum Vorladen der Zeilenleitungen (WL0 bis WLm) auf ein gemeinsames Vorladepotential (V2).

4. Integrierter Speicher nach Anspruch 3,
**dadurch gekennzeichnet, daß**
das Vorlademittel (3) mit wenigstens einer der Spaltenleitungen (BL0 bis BLn) verbunden ist zum Vorladen der Zeilenleitungen (WL0 bis WLm).

5. Integrierter Speicher nach Anspruch 4,
**dadurch gekennzeichnet, daß**
die mit der Speicherzelle (MC2) verbundene Spaltenleitung (BL0) zum Auslesen des Datensignals (DA) mit einem Leseverstärker (3) verbunden ist und das Vorlademittel durch den Leseverstärker (3) gebildet ist.

6. Verfahren zum Betrieb eines integrierten Speichers mit Speicherzellen (MC) mit magnetoresistivem Speichereffekt, die jeweils zwischen eine von mehreren Spaltenleitungen (BL0 bis BLn) und eine von mehreren Zeilenleitungen (WL0 bis WLm) geschaltet sind,
**dadurch gekennzeichnet, daß**
- während eines Auslesevorgangs eine der Zeilenleitungen (WL2) in einer Auswahlschaltung (2) mit einem Anschluß für ein Auswahlsignal (GND) verbunden wird und ein Auslesen eines Datensignals (DA) einer mit der Zeilenleitung (WL2) verbundenen Speicherzelle (MC2) erfolgt,
- die nicht mit der Speicherzelle (MC2) verbundenen Zeilenleitungen (WL0, WL1, WLm) während des Auslesevorgangs in der Auswahlschaltung (2) elektrisch isoliert werden.

7. Verfahren nach Anspruch 6,
**dadurch gekennzeichnet, daß**
die Zeilenleitungen (WL0 bis WLm) auf ein gemeinsames Vorladepotential (V2) vorgeladen werden und nach dem Vorladen das Auslesen des Datensignals (DA) erfolgt.

8. Verfahren nach Anspruch 7,
**dadurch gekennzeichnet, daß**
mit dem Auslesen des Datensignals (DA) so lange gewartet wird bis jeweilige Potentialverläufe auf den Zeilenleitungen (WL0 bis WLm) einen statischen Zustand aufweisen.

9. Verfahren nach Anspruch 7 oder 8,
**dadurch gekennzeichnet, daß**
die Zeilenleitungen (WL0 bis WLm) über wenigstens eine der Spaltenleitungen (BL0 bis BLn) vorgeladen werden.

10. Verfahren nach Anspruch 9,
**dadurch gekennzeichnet, daß**
die eine der Spaltenleitungen (BL0 bis BLn) durch einen Leseverstärker (3) vorgeladen wird.

11. Verfahren nach einem der Ansprüche 6 bis 9,
**dadurch gekennzeichnet, daß**
zum Auslesen des Datensignals (DA) ein Strom (IS) auf der mit der Speicherzelle (MC2) verbundenen Spaltenleitung (BL0) detektiert wird.
